(19) Europäisches Patentamt
European Patent Office
Office européen des brevets

(11) Veröffentlichungsnummer: **0 274 355**
**A2**

# (12) EUROPÄISCHE PATENTANMELDUNG

(21) Anmeldenummer: **87810772.1**

(22) Anmeldetag: **21.12.87**

(51) Int. Cl.[4]: **C 08 G 59/50**
G 03 F 7/00

(30) Priorität: **29.12.86 CH 5226/86**

(43) Veröffentlichungstag der Anmeldung:
**13.07.88 Patentblatt 88/28**

(84) Benannte Vertragsstaaten:
**CH DE FR GB IT LI NL**

(71) Anmelder: **CIBA-GEIGY AG**
**Klybeckstrasse 141**
**CH-4002 Basel (CH)**

(72) Erfinder: **Tieke, Bernd, dr.**
**Route Bel-Air 22**
**CH-1723 Marly (CH)**

## (54) 7,7',8,8'-Tetracyanochinondimethansalze von quaternierten Additionspolymeren.

(57) 1. 7,7',8,8'-Tetracyanochinondimethansalze (TCNQ-Salze) von quaternierten, linearen Additionspolymeren aus Diglycidylverbindungen und primären Monoaminen oder disekundären Diaminen mit einer Viskositätszahl von 0,2 bis 2,0 dl/g, gemessen an einer Lösung von 1,5 g TCNQ-Salz in 100 ml Dimethylformamid bei 30°C, enthaltend die wiederkehrende Strukturenheit der Formel I

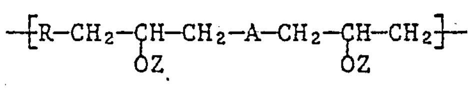

$[TCNQ^{\bullet -}]_m \quad [TCNQ^{\circ}]_n$ (I),

worin
R einen zweiwertigen Rest einer aromatischen, aliphatischen, cycloaliphatischen oder heterocyclischen Diglycidylverbindungen nach Entfernen der beiden Diglycidylgruppen darstellt,
A, bezogen auf die gesamte Anzahl der im Additionspolymer vorhandenen A-Reste, von 100 bis 50 % einen Rest der Formel II oder III

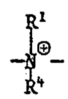 (II) oder 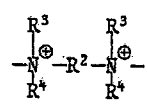 (III)

und von 0 bis 50 % einen Rest der Formel IIa oder IIIa und IIIb

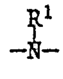 (IIa) oder 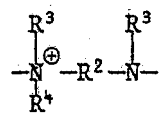 (IIIa)

und 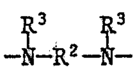 (IIIb)

bedeutet, worin
$R^1$ ein Alkyl, Hydroxyalkyl, Aralkyl, Cycloalkyl, Aryl oder Alkaryl mit bis zu 20 C-Atomen bedeutet,
$R^2$ für Alkylen, Arylen oder Aralkylen mit bis zu 20 C-Atomen, $-CH_2$-$CH_2-\!\!\left(O\text{-}CH_2\text{-}CH_2\right)_x\!\!-$, wobei x Null oder eine Zahl

EP 0 274 355 A2

von 1 bis 5 bedeutet, oder $-CH_2-CH=CH-CH_2-$ steht, $R^3$ je ein Alkyl mit biz zu 12 C-Atomen, Cyclohexyl oder Phenyl oder beide $R^3$ zusammen ein Alkylen mit 2 bis 12 C-Atomen oder $-CH_2-CH_2-(O-CH_2-CH_2)_x-$, wobei x für Null oder eine Zahl von 1 bis 5 steht,

$R^4$ je ein Alkyl mit 1 bis 4 C-Atomen oder Benzyl bedeutet, Z für ein Wasserstoffatom oder ein Acyl mit bis zu 12 C-Atomen steht, m einen Zahlenwert von 0,5 bis 2 und n einen Zahlenwert zwischen Null und 5 bedeuten, $TCNQ^{\bullet -}$ für ein 7,7',8,8'-Tetracyanochinondimethanradikalanion und $TCNQ^{\circ}$ für ein neutrales 7,7',8,8'-Tetracyanochinondimethan stehen, können als elektrisch leitfähige Werkstoffe beispielsweise zur Herstellung von Halbleiterbauteilen oder Sensoren sowie zur elektromagnetischen Abschirmung von elektronischen Bauteilen eingesetzt werden.

**Beschreibung**

7,7′,8,8′-Tetracyanochinondimethansalze von quaternierten Additionspolymeren

Die vorliegende Erfindung betrifft 7,7′,8,8′-Tetracyanochinondimethansalze (TCNQ-Salze) von quaternierten, linearen Additionspolymeren aus Diglycidylverbindungen und primären Monoaminen oder disekundären Diaminen, Verfahren zu deren Herstellung und deren Verwendung als filmbildende Polymere mit Halbleitereigenschaften auf dem Elektroniksektor.

Es ist bekannt, beispielsweise aus Journal of Polymer Science, Part C, No. 16 (1967), Seite 1561ff, Polymer Journal, Vol. 10 (1978), Seite 123ff, Advances in Polymer Science 33 (1979) Seite 93ff, insbesondere Seite 138, und Journal of Polymer Science, Polymer Chemistry Edition, Vol. 21 (1983), Seite 3145ff, dass man durch Umsetzung von 7,7′,8,8′-Tetracyanochinondimethan-Lithium mit quaternierten Polymeren, abgeleitet von Polyvinylpyridinen, Polyvinylimidazolen, Polyethyleniminen oder Poly-4-dimethylaminostyrolen, elektrisch leitfähige Polymere mit filmbildenden Eigenschaften erhält. Durch Dotierung dieser Polymeren mit neutralem 7,7′,8,8′-Tetracyanochinondimethan kann man eine weitere Steigerung der elektrischen Leitfähigkeit erreichen. Für die Verwendung als Halbleiterbauteile sind diese vorbekannten Polymere entweder zu wenig leitfähig oder die aus diesen Polymeren hergestellten Filme sind ziemlich brüchig. Diese Filme lassen sich durch Einführung entsprechender Comonomeren in das Polymermolekül zwar flexibilisieren, doch wird hierbei ihre elektrische Leitfähigkeit vermindert.

Es wurde nun gefunden, dass man durch Umsetzung von quaternierten, linearen, unvernetzten Additionspolymeren aus Diglycidylverbindungen und primären Monoaminen oder disekundären Diaminen mit 7,7′,8,8′- Tetracyanochinondimethan zu den entsprechenden TCNQ-Salzen gelangt, welche flexible sind, gute filmbildende Eigenschaften aufweisen, gut auf Unterlagen haften und gleichzeitig eine relativ hohe elektrische Leitfähigkeit aufweisen.

Gegenstand der Erfindung sind somit TCNQ-Salze von quaternierten, linearen Additionspolymeren aus Diglycidylverbindungen und primären Monoaminen oder disekundären Diaminen mit einer Viskositätszahl von 0,2 bis 2,0 dl/g, gemessen an einer Lösung von 1,5 g TCNQ-Salz in 100 ml Dimethylformamid bei 30° C, enthaltend die wiederkehrende Struktureinheit der Formel I

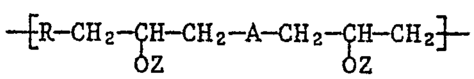 $[TCNQ^{\bullet -}]_m$ $[TCNQ^{\circ}]_n$ (I),

worin

R einen zweiwertigen Rest einer aromatischen, aliphatischen, cycloaliphatischen oder heterocyclischen Diglycidylverbindungen nach Entfernen der beiden Diglycidylgruppen darstellt,

A, bezogen auf die gesamte Anzahl der im Additionspolymer vorhandenen A-Reste, von 100 bis 50 % einen Rest der Formel II oder III

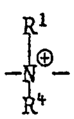 (II) oder 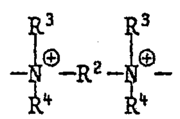 (III)

und von 0 bis 50 % einen Rest der Formel IIa oder IIIa und IIIb

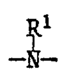 (IIa) oder 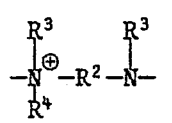 (IIIa) und 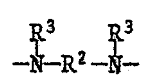 (IIIb)

bedeutet, worin

$R^1$ ein Alkyl, Hydroxyalkyl, Aralkyl, Cycloalkyl, Aryl oder Alkaryl mit bis zu 20 C-Atomen bedeutet,

$R^2$ für Alkylen, Arylen oder Aralkylen mit bis zu 20 C-Atomen, $-CH_2-CH_2-(O-CH_2-CH_2)_x-$ , wobei x Null oder eine Zahl von 1 bis 5 bedeutet, oder $-CH_2-CH=CH-CH_2-$ steht,

$R^3$ je ein Alkyl mit bis zu 12 C-Atomen, Cyclohexyl oder Phenyl oder beide $R^3$ zusammen ein Alkylen mit 2 bis 12 C-Atomen oder $-CH_2-CH_2-(O-CH_2-CH_2)_x-$ , wobei x für Null oder ein Zahl von 1 bis 5 steht,

$R^4$ je ein Alkyl mit 1 bis 4 C-Atomen oder Benzyl bedeutet,

Z für ein Wasserstoffatom oder ein Acyl mit bis zu 12 C-Atomen steht,

m einen Zahlenwert von 0,5 bis 2 und n einen Zahlenwert zwischen Null und 5 bedeuten, $TCNQ^{\bullet -}$ für ein 7,7′,8,8′-Tetracyanochinondi SHY methanradikalanion und $TCNQ^{\circ}$ fur ein neutrales 7,7′,8,8′-Tetracyanochinondimethan stehen.

Vorzugsweise bedeutet in der Formel I der Rest R einen zweiwertigen Rest einer aromatischen Diglycidylverbindung, besonders bevorzugt den Rest eines Bisphenoldiglycidylethers, insbesondere den Rest des Bisphenol A-diglycidylethers.

Der Rest A in der Formel I steht vorzugsweise für einen Rest der Formel III und der Rest Z bedeutet

vorzugsweise ein Wasserstoffatom oder ein Acyl mit 1 bis 4 C-Atomen, insbesondere ein Wasserstoffatom oder Acetyl.

In der Formel II und beziehungsweise IIa stehen $R^1$ vorzugsweise für ein Aryl, Aralkyl oder Cycloalkyl mit bis zu 10 C-Atomen, insbesondere für Phenyl, Benzyl oder Cyclohexyl, und $R^4$ für ein Alkyl mit biz zu 4 C-Atomen, insbesondere Methyl.

In der Formel III, IIIa und beziehungsweise IIIb steht $R^2$ vorzugsweise für ein Alkylen mit bis zu 10 C-Atomen oder $-CH_2-CH_2-(O-CH_2-CH_2)_x-$, wobei x Null oder die Zahl 1 oder 2 bedeutet, bedeuten beide Reste $R^3$ vorzugsweise zusammen ein Alkylen mit 2 bis 10 C-Atomen oder $-CH_2-CH_2-(O-CH_2-CH_2)_x-$, wobei x für Null oder eine Zahl von 1 bis 3 steht, und steht $R^4$ je für ein Alkyl mit bis zu 4 C-Atomen.

Ferner sind solche TCNQ-Salze mit der wiederkehrenden Struktureinheit der Formel I bevorzugt, worin A, bezogen auf die gesamte Anzahl der im Additionspolymer vorhandenen A-Reste, von 100 bis 75 % einen Rest der Formel II oder III, insbesondere einen Rest der Formel III, un von 0 bis 25 % einen Rest der Formel IIa, IIIa oder IIIb, insbesondere einen Rest der Formel IIIa oder IIIb, bedeutet.

Die 7,7',8,8'-Tetracyanochinondimethansalze (TCNQ-Salze) mit der wiederkehrenden Struktureinheit der Formel I können hergestellt werden, indem man quaternierte, lineare Additionspolymere aus Diglycidylverbindungen und primären Monoaminen oder disekundären Diaminen mit einer Viskositätszahl von 0,2 bis 2,0 dl/g, gemessen an einer Lösung von 1,5 g Additionspolymer in 100 ml Dimethylformamid bei 30° C, enthaltend die wiederkehrende Struktureinheit der Formel IV

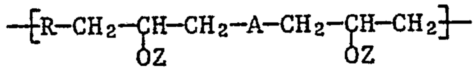 (IV),

worin R und Z die gleiche Bedeutung wie in Formel I haben und A, bezogen auf die gesamte Anzahl der im Additionspolymer vorhandenen A-Reste, von 100 bis 50 % einen Rest der Formel V oder VI

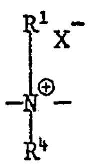 (V) oder 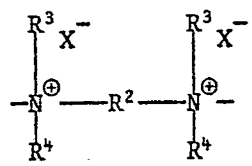 (VI)

und von 0 bis 50 % einen Rest der Formel Va oder VIa und VIb

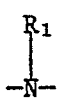 (Va) oder 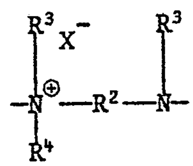 (VIa) und 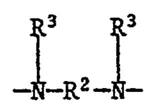 (VIb)

bedeutet, worin $R^1$, $R^2$, $R^3$ und $R^4$ die gleiche Bedeutung wie in Formeln II oder III haben, $X^-$ für $Br^-$, $J^-$, 1/2 $SO_4^{2-}$, 1/3 $PO_4^{3-}$ oder Tosylat steht, mit 7,7',8,8'-Tetracyanochinondimethan-Lithium umsetzt, wobei man auf 1 Mol der quaternären Ammoniumionen in der wiederkehrenden Struktureinheit der Formel IV 1 bis 1,5 Mol 7,7',8,8'-Tetracyanochinondimethan-Lithium einsetzt, und anschliessend das erhaltene TCNQ-Salz der Formel I, worin n Null ist, mit 0 bis 5 Molen 7,7',8,8'-Tetracyanochinondimethan dotiert.

Vorzugsweise geht man dabei von solchen quaternierten Additionspolymeren mit der wiederkehrenden Struktureinheit der Formel IV aus, worin A von 100 bis 75 % einen Rest der Formel V oder VI, insbesondere der Formel VI, und von 0 bis 25 % einen Rest der Formel Va oder VIa und VIb, insbesondere der Formel VIa und VIb, bedeutet.

Ferner setzt man bevorzugt solche quaternierten Additionspolymeren mit der wiederkehrenden Struktureinheit der Formel IV ein, worin R, Z und die Substituenten $R^1$, $R^2$, $R^3$ und $R^4$ im Rest A der Formel V und VI und beziehungsweise in Formel Va, VIa und VIb die gleiche bevorzugte Bedeutung wie in Formel I, II oder III und beziehungsweise in Formel IIa, IIIa oder IIIb haben.

Die quaternierten Additionspolymeren mit der wiederkehrenden Struktureinheit der Formel IV sind beispielsweise aus Journal of Polymer Science, Polymer Chemistry Edition. Vol. 22, (1984), Seite 249ff bekannt und können nach dem dort offenbarten Verfahren hergestellt werden, indem man lineare Additionspolymere, enthaltend die wiederkehrende Struktureinheit der Formel IV, worin R und Z die gleiche Bedeutung wie in Formel I haben und A einen Rest der Formel Va oder VIb bedeutet, worin $R^1$, $R^2$ und $R^3$ die gleiche Bedeutung wie in Formel II oder III haben, in bekannter Weise mit einem Quaternierungsmittel der Formel VII

$R^4$-X (VII),

worin $R^4$ die gleiche Bedeutung wie in Formel II oder III hat, und X für ein Brom- oder Jodatom steht, oder mit Dimethyl-, Diethylsulfat, Trimethyl-, Triethylphosphat oder mit einem Tosylat (Ester der p-Toluolsulfonsäure) als Quaternierungsmittel in solchem Mengen umsetzt, dass das erhaltene quaternierte Additionspolymere

einen Quaternierungsgrad von mindestens 50 %, bezogen auf alle im Additionspolymeren vorhandenen N-Atome, aufweist.

Vorzugsweise werden solche Mengen an Quaternierungsmittel eingesetzt, dass die quaternierten Aditionspolymeren einen Quaternierungsgrad von mindestens 75 % aufweisen.

Bedeutet in der wiederkehrenden Struktureinheit der Formel I der Rest Z ein Acyl, so kan die Veresterung der entsprechenden OH-Gruppe zur Gruppe -OZ vor oder nach der Quaternierung des Additionspolymeren mit einer entsprechenden Carbonsäure oder deren Anhydrid in bekannter Weise vorgenommen werden.

Die Herstellung der zur Quaternierung eingesetzten linearen Additionspolymeren kann nach einem der in Journal of Polymer Science, Polymer Chemistry Edition, Vol. 22 (1984), Seite 249ff, in Makromolekulare Chemie, Rapid Commun. 2 (1981), Seite 113ff oder in Zeitschrift für Chemie 22, (1982), Seite 166ff offenbarten Verfahren durchgeführt werden, indem man eine Diglycidylverbindung mit einem primären Monoamin oder einem disekundären Diamin in äquimolaren Mengen lösungsmittelfrei bei Temperaturen bis zu 200°C oder in einem organischen Lösungsmittel, vorzugsweise in einem aprotischen Lösungsmittel, wie Dimethylformamid, Dimethylsulfoxid oder 2-Methoxyethanol, unter Rückfluss des Lösungsmittels umsetzt.

Als Diglycidylverbindung können dabei Diglycidylester, -ether, -thioether oder Diglycidylverbindungen von Monoaminen oder N,N-heterocyclischen Verbindungen eingesetzt werden. Die Diglycidylester können sich von aliphatischen Dicarbonsäuren, z.B. Oxalsäure, Bernsteinsäure, Glutarsäure, Adipinsäure, Pimelinsäure, Korksäure, Azelainsäure oder Sebacinsäure, von cycloaliphatischen Dicarbonsäuren, wie Tetrahydrophthalsäure, 4-Methyltetrahydrophthalsäure, Hexahydrophthalsäure und 4-Methylhexahydrophthalsäure sowie von aromatischen Dicarbonsäuren, wie Phthalsäure, Isophthalsäure und Terepthalsäure, ableiten.

Geeignete Diglycidylether sind beispielsweise solche die durch Glycidylierung von acyclischen Diolen, wie Ethylenglykol, Diethylenglykol und höheren Poly-(oxyethylen)-glykolen, Propan-1,2-diol und Poly-(oxypropylen)-glykolen, Propan-1,3-diol, Butan-1,4-diol, Poly-(oxytetramethylen)-glykolen, Pentan-1,5-diol oder Hexan-1,6-diol, von cycloaliphatisichen Diolen, wie Resorcit, Chinit, Bis-(4-hydroxycyclohexyl)-methan, 2,2-Bis-(4-hydroxycyclohexyl)-propan und 1,1-Bis-(hydroxymethyl)-3-cyclohexan, von einkernigen zweiwertigen Phenolen, wie Resorcin und Hydrochinon, und von mehrkernigen zweiwertigen Phenolen, wie Bis-(4-hydroxyphenyl)-methan, 4,4′-Di-hydroxydiphenyl, Bis-(4-hydroxyphenyl)-sulfon, 1,1,2,2-Tetrakis-(4-hydroxyphenyl)-ethan, 2,2-Bis-(4-hydroxyphenyl)-propan (Bisphenol A) oder 2,2-Bis-(3,5-dibrom-4-hydroxyphenyl)-propan, ableiten.

Ferner eigenen sich als Diglycidylverbindungen beispielsweise auch solche, die sich von Monoaminen, wie Anilin oder n-Butylamin, von cyclischen Alkylenharnstoffen, wie Aethylenharnstoff und 1,3-Propylenharnstoff, von Hydantoinen, wie 5,5-Dimethylhydantoin, oder von Dithiolen, wie Ethan-1,2-dithiol, ableiten. Vorzugsweise verwendet man zur Herstellung der linearen Additionspolymeren aromatische Diglycidylverbindungen, besonders bevorzugt die Bisphenoldiglycidylether, insbesondere einen Bisphenol A-diglycidylether.

Als primäre Monoamine können zur Herstellung der linearen Additionspolymeren beispielsweise Monoethanolamin, Propanolamin, 3-Hydroxypropylamin, Butylamin, 2-Ethylhexylamin, n-Octylamin, 2-Butoxyethylamin, Dodecylamin, Stearylamin, Oleylamin, Anilin m- oder p-Toluidin, 1-Naphthylamin, 2-Phenyläthylamin oder Cyclohexylamin verwendet werden, wobei man bevorzugt aromatische, araliphatische oder cycloaliphatische Monoamine, insbesondere Anilin, Benzylamin oder Cyclohexylamin, einsetzt.

Zur Herstellung der linearen Additionspolymeren verwendet man bevorzugt die disekundären Diamine, wie beispielsweise Piperazin, N,N′-Dicyclohexylhexamethylendiamin-1,6, 2,3-Benzo-1,4-diaza-7-oxa cyclononan, 2,3-Benzo-1,4-diaza-7,10-dioxa-cylcodecan, 2,3-Benzo-1,4-diaza-7,10,13-trioxa-cyclopentadecan oder 1,7-Diaza-4,10-dioxacyclodecan, insbesondere verwendet man Piperazin.

Die erfindungsgemässen polymeren TCNQ-Salze stellen grüne bis dunkelgrüne Pulver dar, die in organischen, polaren Lösungsmitteln gut löslich sind. Die aus den erfindungsgemässen TCNQ-Salzen hergestellten Pulverpresslinge weisen eine spezifische Leitfähigkeit von mindestens $10^{-9}$ $S.cm^{-1}$, vorzugsweise von mindestens $10^{-7}$ $S.cm^{-1}$ und eine Viskositätszahl von 0,2 bis 2,0 dl/g auf, gemessen an einer 1,5%igen Lösung in Dimethylformamid bei 30°C, was einem mittleren Molekulargewichtsbereich von 2000 bis etwa 120'000 entspricht.

Die erfindungsgemässen polymeren TCNQ-Salze mit der wiederkehrenden Struktureinheit der Formel I eignen sich zur Herstellung selbsttragender, elektrisch leitfähiger Filme mit hoher Glasumwandlungstemperatur, Reissfestigkeit und Flexibilität. Solche Filme können auf dem Gebiet der Elektronik bzw. Mikroelektronik Anwendung finden, beispielsweise als elektrisch leitfähige Werkstoffe bei der Herstellung von elektrischen Leitern, Schaltern oder Halbleiterbauteilen, sowie zur elektromagnetischen Abschirmung von elektronischen Bauteilen. Die erfindungsgemässen polymeren TCNQ-Salze sind auch zur Herstellung von Sensoren (Thermistoren) verwendbar.

Bei der Herstellung der erfindungsgemässen polymeren TCNQ-Salze wurde von linearen Epoxid-Amin-Additionspolymeren ausgegangen. Diese wurden nach einer im Journal of Polymer Science, Polymer Chemistry Edition, Vol. 22, (1984) Seite 249ff beschriebenen Vorschrift synthetisiert. Aequimolare Mengen aus primären Monoaminen bzw. disekundären Diaminen und Bisphenol A-diglycidylether (Epoxidäquivalentgewicht 170) wurden in 2-Methoxyethanol gelöst (20 gewichtsprozentige Lösung) und 24 Stunden zum Sieden erhitzt. Nach dem Abkühlen wurde das Polymer im 10fachen Volumen Eiswasser ausgefällt und nach 4-maligem Waschen mit je 500 ml Wasser getrocknet. Die Eigenschaften der Polymeren (I bis III) sind in Tabelle 1 beschrieben.

Tabelle 1: Liste der verwendeten Epoxid-Amin-Additionspolymeren

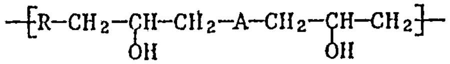

| Polymer | R | A | hergestellt aus (Molverhältnis | $\bar{M}n$ *1) | $\bar{M}w$ *1) | $\frac{\eta\ spez.}{c}$ *2) [dl/g] | Elementaranalyse (Bruttoformel der Struktureinheit) ber.[%] gef.[%] |
|---|---|---|---|---|---|---|---|
| I | 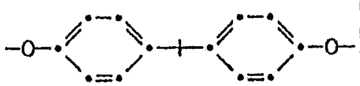 | 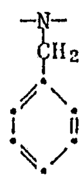 | Bisphenol A-diglycidylether Benzylamin (1:1) | 6,5 x $10^3$ | 2,8 x $10^4$ | 0.261 | ($C_{28}H_{33}NO_4$) C 75,14 74,48<br>H 7,43 7,47<br>N 3,13 2,93 |
| II | 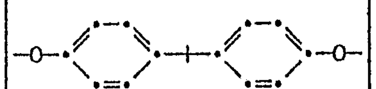 | 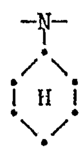 | Bisphenol A-diglycidylether Cyclohexylamin (1:1) | 6,3 x $10^3$ | 2,7 x $10^4$ | 0,247 | ($C_{27}H_{37}NO_4$) C 73,77 73,17<br>H 8,48 8,46<br>N 3,19 2,99 |
| III | 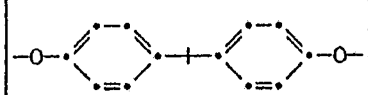 | 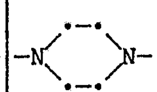 | Bisphenol A-diglycidylether Piperazin (1:1) | 3,5 x $10^3$ | 1,3 x $10^4$ | 0,534 | ($C_{25}H_{34}NO_4$) C 70,40 68,22<br>H 8,03 7,99<br>N 6,57 6,37 |

*1) ermittelt durch Gelpermeationschromatographie (stat. Phase: Ultrastyragel, mit Poren-Ø $10^6$, $10^5$, $10^4$, $10^3$Å; mobile Phase: THF; T = 22 ± 1°C; Flussrate: 0,96 ml/min).

*2) Viskositätszahl gemessen in DMF bei 30°C (Ubbelohde-Viskosimeter, c = 1,5 g/dl)

Beispiel 1:

15 g Polymer I werden in 100 ml Dimethylformamid (DMF) gelöst. Danach werden 14,2 g Methyljodid zugegeben und die Reaktionsmischung 5 Tage bei 40° C gerührt. Nach dem Abkühlen wird das Polymer in 1,5 Liter Wasser ausgefällt. Es entsteht ein weisser Niederschlag der abfiltriert, 3 mal mit je 200 ml Wasser gewaschen und schliesslich bei 50° C im Vakuum getrocknet wird. Die Ausbeute an quaterniertem Polymer IV beträgt 14,8 g. Jodgehalt, Quaternierungsgrad und Viskositätszahl sind in Tabelle 2 angegeben.

1 g quaterniertes Polymer IV wird in 10 ml DMF gelöst und mit 1,1 g 7,7',8,8'-Tetracyanochinondimethan-Lithium (Li-TCNQ) in 50 ml DMF versetzt. Nach kurzem Rühren wird das entstandene polymere TCNQ-Salz durch Eingiessen der DMF-Lösung in 200 ml Wasser ausgefällt. Der entstehende dunkelgrüne Niederschlag wird abfiltriert, mit 100 ml Wasser gewaschen und im Vakuum getrocknet. Es werden 0,7 g eines dunkelgrünen, gut in DMF oder Aceton löslichen Pulvers erhalten, dessen charakteristische Daten in Tabelle 3 aufgeführt sind.

Beispiel 2:

1,5 g Polymer II werden in 100 ml DMF gelöst. Danach werden 14,2 g Methyljodid zugegeben und die Reaktionsmischung 5 Tage bei 40° C gerührt. Nach dem Abkühlen wird das quaternierte Polymer in 1,5 Liter Wasser ausgefällt. Es entsteht ein weisser Niederschlag, der abfiltriert, dreimal mit 200 ml Wasser gewaschen und schliesslich bei 50° C im Vakuum getrocknet wird. Die Ausbeute an quaterniertem Polymer V liegt bei 14,9 g. Jodgehalt, Quaternierungsgrad und Viskositätszahl sind in Tabelle 2 angegeben.

1 g quaterniertes Polymer V wird in 10 ml DMF gelöst und mit 1,1 g (Li-TCNQ) in 50 ml DMF versetzt. Nach kurzem Rühren wird das entstandene polymere TCNQ-Salz durch Eingiessen der DMF-Lösung in 200 ml Wasser ausgefällt. Der entstehende dunkelgrüne Niederschlag wird abfiltriert, dreimal mit je 20 ml Isopropanol gewaschen und im Vakuum getrocknet. Es werden 0,5 g eines dunkelgrünen, gut in DMF oder Aceton löslichen Pulvers erhalten, dessen charakteristische Daten in Tabelle 3 aufgeführt sind.

Beispiel 3:

15 g Polymer III werden in 100 ml DMF gelöst. Danach werden 70.7 g Methyljodid zugegeben und die Reaktionsmischung 48 Stunden bei 70° C gerührt. Nach dem Abkühlen wird das Polymere in 4 Liter Wasser ausgefällt. Es entsteht ein weisser Niederschlag, der abfiltriert, dreimal mit je 200 ml Wasser gewaschen und anschliessend bei 50° C im Vakuum getrocknet wird. Die Ausbeute an quaterniertem Polymer VI beträgt 17,9 g. Jodgehalt, Quaternierungsgrad und Viskositätszahl sind in Tabelle 2 angegeben.

3,2 g quaterniertes Polymer VI werden in 25 ml DMF gelöst und mit 2,1 g Li-TCNQ in 50 ml DMF versetzt. Nach kurzem Rühren wird das entstandene polymere TCNQ-Salz durch Eingiessen der DMF-Lösung in 500 ml Wasser ausgefällt. Der entstehende dunkelgrüne Niederschlag wird abfiltriert, zweimal mit je 25 ml Wasser, 4-mal mit je 20 ml Ethanol und zweimal mit je 20 ml Ether gewaschen und schliesslich im Vakuum getrocknet. Es werden 3,7 g eines dunkelgrünen, gut in DMF oder Aceton löslichen Pulvers erhalten, dessen charakteristische Daten in Tabelle 3 aufgeführt sind.

Beispiel 4:

7,1 g quaterniertes Polymer VI gemäss Beispiel 3 werden in 50 ml DMF gelöst und innerhalb von 5 Minuten mit 10,2 g Acetanhydrid versetzt. Nach 12-stündigem Rühren bei 60° C wird das Polymer durch Eingiessen der DMF-Lösung in 1,5 Liter 5%ige wässrige Kaliumjodidlösung ausgefällt. Der entstehende weisse Niederschlag wird abfiltriert und solange mit Wasser gewaschen, bis kein Jodid mehr aus dem Polymeren eluiert wird. Dann wird nacheinander dreimal mit je 25 ml Ethanol und zweimal mit je 25 ml Ethere gewaschen und bei 60° C im Vakuum getrocknet. Es werden 6,9 g acetyliertes, quaterniertes Polymer VII erhalten. Jodgehalt, Quaternierungsgrad und Viskositätszahl sind in Tabelle 2 angegeben.

2,0 g acetyliertes quaterniertes Polymer VII werden in 10 ml DMF gelöst und mit 2,1 g Li-TCNQ in 15 ml DMF versetzt. Nach kurzem Rühren wird das polymere TCNQ-Salz durch Eingiessen der DMF-Lösung in 500 ml Wasser ausgefällt. Der dunkelgrüne Niederschlag wird abfiltriert und nacheinander zweimal mit je 25 ml Wasser, 5 mal mit je 25 ml Ethanol und zweimal mit je 25 ml Ether gewaschen. Dann wird im Vakuum getrocknet. Es werden 2,2 g eines dunkelgrünen, gut in DMF oder Aceton löslichen Pulvers erhalten, dessen charakteristische Daten in Tabelle 3 aufgeführt sind.

Beispiel 5:

4,3 g des nach Beispiel 3 hergestellten polymeren TCNQ-Salzes werden in 50 ml DMF gelöst. Zu dieser Lösung werden 80 ml einer 7,7',8,8'-Tetracyanochinondimethan-Lösung (TCNQ-Lösung) in DMF (Konzentration 12,8 g/l) hinzugegeben. Nach kurzem Rühren wird das polymere, dotierte TCNQ-Salz durch Eingiessen der DMF-Lösung in ein 15-faches Volumen Wasser ausgefällt. Der entstehende dunkelgrüne Niederschlag wird abfiltriert und nacheinander zweimal mit je 100 ml Wasser, 5 mal mit je 150 ml Ethanol und dreimal mit je 150 ml Ether gewaschen. Schliesslich wird bei 50°C im Vakuum getrocknet. Es werden 4,0 g eines dunkelgrünen, gut in DMF oder Aceton löslichen Pulvers erhalten, dessen charakteristische Daten in Tabelle 3 aufgeführt sind.

Beispiel 6:
Es wird wie in Beispiel 5 verfahren. In Abänderung werden 160 ml der TCNQ-Lösung zur Lösung des polymeren TCNQ-Salzes hinzugegeben. Nach der Aufarbeitung werden 4,1 g eines dunkelgrünen, gut in DMF oder Aceton löslichen Pulvers erhalten, dessen charakteristische Daten in Tabelle 3 aufgeführt sind.

Beispiel 7:
Es wird wie in Beispiel 5 verfahren. In Abänderung werden 320 ml der TCNQ-Lösung zur Lösung des polymeren TCNQ-Salzes hinzugegeben. Nach der Aufarbeitung werden 5,1 g eines grünen, gut in DMF oder Aceton löslichen Pulvers erhalten, dessen charakteristische Daten in Tabelle 3 aufgeführt sind.

Beispiel 8:
1,0 g des nach Beispiel 4 hergestellten polymeren TCNQ-Salzes wird in 10 ml DMF gelöst. Zu dieser Lösung werden 8 ml einer TCNQ-Lösung in DMF (Konzentration 12,8 g/l) hinzugegeben. Nach kurzem Rühren wird das polymere, dotierte TCNQ-Salz durch Eingiessen der DMF-Lösung in ein 15faches Volumen Wasser ausgefällt. Der entstehende feine, dunkelgrüne Niederschlag wird abfiltriert und nacheinander zweimal mit je 20 ml Wasser, 5 mal mit je 30 ml Ethanol und dreimal mit je 30 ml Ether gewaschen. Dann wird im Vakuum getrocknet. Es werden 0,3 g eines dunkelgrünen, gut in DMF oder Aceton löslichen Pulvers erhalten, dessen charakteristische Daten in Tabelle 3 aufgeführt sind.

Beispiel 9:
Es wird wie in Beispiel 8 verfahren. In Abänderung werden 16 ml der TCNQ-Lösung zur Lösung des polymeren TCNQ-Salzes hinzugegeben. Nach der Aufarbeitung werden 0,6 g eines dunkelgrünen, gut in DMF oder Aceton löslichen Pulvers erhalten, dessen charakteristische Daten in Tabelle 3 aufgefürt sind.

Beispiel 10:
Es wird wie in Beispiel 8 verfahren. In Abänderung werden 32 ml der TCNQ-Lösung zur Lösung des polymeren TCNQ-Salzes hinzugegeben. Nach der Aufarbeitung werden 0,9 g eines dunkelgrünen, gut in DMF oder Aceton löslichen Pulvers erhalten, dessen charakteristische Daten in Tabelle 3 aufgeführt sind.

Tabelle 2: Charakteristische Daten der quaternierten Polymeren

| Quaterniertes Polymer | Jodgehalt pro Struktureinheit in % | Quaternierungsgrad pro Struktureinheit in % | η sp/c *1) [dl/g] |
|---|---|---|---|
| IV | 25,1 | 100 | 0,550 |
| V | 20,7 | 95,9 | 0,434 |
| VI | 33,3 | 91,2 | 0,984 |
| VII | 27,1 | 83,1 | 0,684 |

*1) Viskositätszahl gemessen in DMF bei 30°C (Ubbelohde-Viskosimeter, c = 1,5 g/dl)

Tabelle 3: Charakteristische Daten der polymeren TCNQ-Salze

| Beispiel | η sp/c *1) [dl/g] | Spezif. Leitfähigkeit σ *2) $[S \cdot cm^{-1}]$ | $\frac{TCNQ^{\circ}}{TCNQ^{-\bullet}}$ *3) |
|---|---|---|---|
| 1 | 0,628 | $1,2 \times 10^{-9}$ | 0 |
| 2 | 0,592 | $3,1 \times 10^{-9}$ | 0 |
| 3 | 1,15 | $3,3 \times 10^{-7}$<br>$4,5 \times 10^{-6}$ *4) | 0 |
| 4 | 0,981 | $2,0 \times 10^{-8}$<br>$1,0 \times 10^{-7}$ *4) | 0 |
| 5 | 1,19 | $5,5 \times 10^{-5}$<br>$8,8 \times 10^{-4}$ *4) | 0,5 |
| 6 | 1,10 | $1,9 \times 10^{-5}$ | 1 |
| 7 | 1,00 | $3,9 \times 10^{-6}$ | 2 |
| 8 | 0,891 | $3,0 \times 10^{-6}$ | 0,5 |
| 9 | 0,794 | $2,3 \times 10^{-6}$ | 1 |
| 10 | 0,657 | $5,7 \times 10^{-7}$ | 2 |

*1) Viskositätszahl gemessen in DMF bei 30°C (Ubbelohde-Viskosimeter, c = 1,5 g/dl)

*2) σ gemessen an Pulverpresslingen bei 20°C

*3) berechnet nach der zugesetzten TCNQ°-Menge

*4) σ gemessen an Pulverpresslingen bei 100°C

**Patentansprüche**

1. 7,7′,8,8′-Tetracyanochinondimethansalze (TCNQ-Salze) von quaternierten, linearen Additionspolymeren aus Diglycidylverbindungen und primären Monoaminen oder disekundären Diaminen mit einer Viskositätszahl von 0,2 bis 2,0 dl/g, gemessen an einer Lösung von 1,5 g TCNQ-Salz in 100 ml Dimethylformamid bei 30° C, enthaltend die wiederkehrende Struktureinheit der Formel I

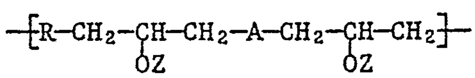 $[TCNQ^{\bullet -}]_m$ $[TCNQ^{\circ}]_n$ (I),

worin
R einen zweiwertigen Rest einer aromatischen, aliphatischen, cycloaliphatischen oder heterocyclischen Diglycidylverbindungen nach Entfernen der beiden Diglycidylgruppen darstellt,
A, bezogen auf die gesamte Anzahl der im Additionspolymer vorhandenen A-Reste, von 100 bis 50 % einen Rest der Formel II oder III

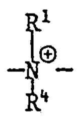 (II) oder 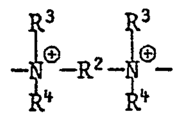 (III)

und von 0 bis 50 % einen Rest der Formel IIa oder IIIa und IIIb

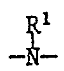 (IIa); 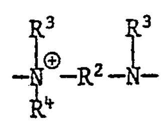 (IIIa) oder 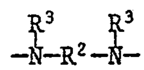 (IIIb)

bedeutet, worin
$R^1$ ein Alkyl, Hydroxyalkyl, Aralkyl, Cycloalkyl, Aryl oder Alkaryl mit bis zu 20 C-Atomen bedeutet,
$R^2$ für Alkylen, Arylen oder Aralkylen mit bis zu 20 C-Atomen, $-CH_2-CH_2-(O-CH_2-CH_2)_x-$, wobei z Null oder eine Zahl von 1 bis 5 bedeutet, oder $-CH_2-CH=CH-CH_2-$ steht,
$R^3$ je ein Alkyl mit bis zu 12 C-Atomen Cyclohexyl oder Phenyl oder beide $R^3$ zusammen ein Alkylen mit 2 bis 12 C-Atomen oder $-CH_2-CH_2-(O-CH_2-CH_2)_x-$, wobei x für Null oder eine Zahl von 1 bis 5 steht,
$R^4$ je ein Alkyl mit 1 bis 4 C-Atomen oder Benzyl bedeutet, Z für ein Wasserstoffatom oder ein Acyl mit bis zu 12 C-Atomen steht,
m einen Zahlenwert von 0,5 bis 2 und n einen Zahlenwert zwischen Null und 5 bedeuten, TCNQ für ein 7,7′,8,8′-Tetracyanochinondimethanradikalanion und TCNQ° für ein neutrales 7,7′,8,8′-Tetracyanochinondimethan stehen.

2. TCNQ-Salze gemäss Anspruch 1, worin R in der Formel I für einen zweiwertigen Rest einer aromatischen Diglycidylverbindung steht.

3. TCNQ-Salze gemäss Anspruch 1, worin R in der Formel I für einen zweiwertigen Rest eines Bisphenoldiglycidylethers steht.

4. TCNQ-Salze gemäss Anspruch 1, worin R in der Formel I für einen zweiwertigen Rest eines Bisphenol A-diglycidylethers steht.

5. TCNQ-Salze gemäss Anspruch 1, worin A von 100 bis 75 % einen Rest der Formel II oder III und von 0 bis 25 % einen Rest der Formel IIa, IIIa oder IIIb bedeutet.

6. TCNQ-Salze gemäss Anspruch 1, worin A in der Formel I für einen Rest der Formeln III, IIIa und IIIb steht.

7 TCNQ-Salze gemäss Anspruch 1, worin in Formel III, IIIa und IIIb $R^2$ für ein Alkylen mit biz zu 10 C-Atomen oder $-CH_2-CH_2-(O-CH_2-CH_2)_x-$, wobei x Null oder die Zahl 1 oder 2 bedeutet, steht, beide Reste $R^3$ ein Alkylen mit 2 bis 10 C-Atomen oder zusammen $-CH_2-CH_2-(O-CH_2-CH_2)_x-$, wobei x für Null oder eine Zahl von 1 bis 3 steht, bedeuten und $R^4$ je für ein Alkyl mit biz zu 4 C-Atomen bedeutet.

8. Verfahren zur Herstellung von 7,7′,8,8′-Tetracyanochinondimethansalzen (TCNQ-Salzen) nach Anspruch 1 mit der wiederkehrenden Struktureinheit der Formel I, dadurch gekennzeichnet, dass man quaternierte, lineare Additionspolymere aus Diglycidylverbindungen und primären Monoaminen oder disekundären Diaminen mit einer Viskositätszahl von 0,2 bis 2,0 dl/g, gemessen an einer Lösung von 1,5 g Additionspolymer in 100 ml Dimethylformamid bei 30° C, enthaltend die wiederkehrende Struktureinheit der Formel IV

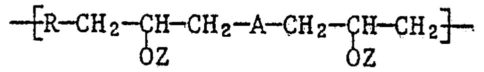 (IV),

worin R und Z die gleiche Bedeutung wie in Formel I haben und A, bezogen auf die gesamte Anzahl der im Additionspolymer vorhandenen A-Reste, von 100 bis 50 % einen Rest der Formel V oder VI

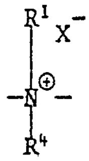 (V) oder 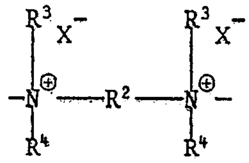 (VI)

und von 0 bis 50 % einen Rest der Formel Va oder VIa und VIb

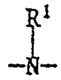 (Va) oder 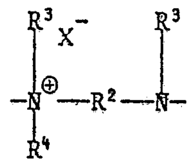 (VIa) und 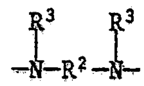 (VIb)

bedeutet, worin $R^1$, $R^2$, $R^3$ und $R^4$ die gleiche Bedeutung wie in Formeln II oder III haben, $X^-$ für $Br^-$, $J^-$, $1/2\,SO_4{}^{2-}$, $1/3\,PO_4{}^{3-}$ oder Tosylat steht, mit 7,7',8,8'-Tetracyanochinondimethan-Lithium umsetzt, wobei man auf 1 Mol der quaternären Ammoniumionen in der wiederkehrenden Struktureinheit der Formel IV 1 bis 1,5 Mol 7,7',8,8'-Tetracyanochinondimethan-Lithium einsetzt, und anschliessend das erhaltene TCNQ-Salz der Formel I, worin n Null ist, mit 0 bis 5 Molen 7,7',8,8'-Tetracyanochinondimethan dotiert.

9. Verfahren gemäss Anspruch 8, dadurch gekennzeichnet, dass man quaternierte Additionspolymere mit der wiederkehrenden Struktureinheit der Formel IV einsetzt, worin A von 100 bis 75 % einen Rest der Formel V oder VI und von 0 bis 25 % einen Rest der Formel Va oder VIa und VIb bedeutet.

10. Verwendung der TCNQ-Salze gemäss Anspruch 1 zur Herstellung von Halbleiterbauteilen oder Sensoren.